(19) **Europäisches Patentamt / European Patent Office / Office européen des brevets**

(11) **EP 1 982 379 B1**

(12) **EUROPEAN PATENT SPECIFICATION**

(45) Date of publication and mention of the grant of the patent:
**17.03.2010 Bulletin 2010/11**

(21) Application number: **07705492.2**

(22) Date of filing: **30.01.2007**

(51) Int Cl.:
*H01M 8/04* $^{(2006.01)}$      *B60L 11/18* $^{(2006.01)}$

(86) International application number:
**PCT/IB2007/000212**

(87) International publication number:
**WO 2007/085956 (02.08.2007 Gazette 2007/31)**

(54) **FUEL CELL SYSTEM AND METHOD FOR ESTIMATING OUTPUT CHARACTERISTIC OF FUEL CELL**

BRENNSTOFFZELLENSYSTEM UND VERFAHREN ZUR SCHÄTZUNG DER AUSGABEEIGENSCHAFTEN EINER BRENNSTOFFZELLE

SYSTÈME DE PILE À COMBUSTIBLE ET PROCÉDÉ POUR L'ESTIMATION DE CARACTÉRISTIQUE DE SORTIE DE PILE À COMBUSTIBLE

(84) Designated Contracting States:
**DE FR GB IT**

(30) Priority: **30.01.2006 JP 2006021486**

(43) Date of publication of application:
**22.10.2008 Bulletin 2008/43**

(73) Proprietor: **Toyota Jidosha Kabushiki Kaisha Toyota-shi, Aichi-ken, 471-8571 (JP)**

(72) Inventor: **WATANABE, Nobuo Toyota-shi, Aichi-ken 471-8571 (JP)**

(74) Representative: **Kuhnen & Wacker Patent- und Rechtsanwaltsbüro Prinz-Ludwig-Strasse 40A 85354 Freising (DE)**

(56) References cited:
**EP-A- 1 209 023        EP-A2- 0 716 463
US-A- 4 904 548        US-A1- 2003 141 188
US-A1- 2004 214 061**

## Description

BACKGROUND OF THE INVENTION

1. Field of the invention

The present invention relates to a fuel cell system and a method for estimating an output characteristic of a fuel cell.

2. Description of the Related Art

In order to improve the power generation efficiency of a fuel cell, a control in which the fuel cell output is determined taking the current-voltage characteristic (which is hereinafter referred to as "output characteristic") of the fuel cell into account is conventionally performed. However, the current-voltage characteristic changes depending on the conditions of the fuel cell or over time. Thus, a related art is suggested in, for example, JP-A-2002-231295 in which the output characteristic of a fuel cell is estimated from the temperature of the fuel cell, hydrogen pressure or the like and the output of the fuel cell is controlled using the estimated output characteristic to operate the fuel cell efficiently.

In the above related art, however, the output characteristic of the fuel cell is derived from only the hydrogen supply pressure and the temperature of the fuel cell. Other operation parameters, which have a large influence on the output characteristic of the fuel cell, are not taken into account. Therefore, high estimation accuracy cannot necessarily be obtained.

SUMMARY OF THE INVENTION

The present invention improves the accuracy of estimation of an output characteristic of a fuel cell.

A first aspect of the present invention relates to a fuel cell system. The fuel cell system has: an operation parameter storing unit that stores the relation between an internal resistance of a fuel cell excluding both a diffusion resistance of the fuel cell that is generated depending on the flow rate of reaction gas to the fuel cell and a reaction resistance of the fuel cell that is generated depending on the pressure of the reaction gas, and at least one operation parameter indicating an operating state of the fuel cell; a detecting unit that detects the present value of the at least one operation parameter of the fuel cell; an internal resistance estimating unit that estimates the internal resistance of the fuel cell based on the detected value of the operation parameter, with reference to the relation stored in the operation parameter storing unit, and sets the estimated internal resistance as the basic internal resistance; an IR-free (internal resistance-free) output characteristic storing unit that stores the IR-free output characteristic, which is the relation between output current and output voltage of the fuel cell, excluding the influence of the internal resistance, at different flow rates and pressures of air supplied to the fuel cell, together with the flow rate and the pressure; a flow rate measuring unit that measures the flow rate of the air to be supplied to the fuel cell; a pressure measuring unit that measures the pressure of the air; a determining unit that determines the IR-free output characteristic of the fuel cell based on the flow rates and pressures of the air; and a setting unit that sets a basic output characteristic of the fuel cell based on the basic internal resistance and the IR-free output characteristic. In the above configuration, the fuel cell system may further have: an output current measuring unit that measures the output current of the fuel cell; an output voltage measuring unit that measures the output voltage of the fuel cell outputting the output current; and a calculating unit that corrects the basic output characteristic based on the output current and the output voltage.

According to the fuel cell system, the IR-free output characteristic is the relation between output current and output voltage of the fuel cell excluding the influence of the internal resistance at different flow rates and pressures of air supplied to the fuel cell. The IR-free output characteristic is stored together with the flow rate and the pressure. The flow rate and pressure of air to be supplied to the fuel cell is measured and an IR-free output characteristic of the fuel cell is determined based on the measured flow rate and pressure of the air. Therefore, the basic output characteristic of the fuel cell can be estimated accurately, and, consequently, the basic output characteristic can be corrected accurately.

The operation parameter may include at least one of the temperature of the fuel cell, the humidity in the fuel cell, and an impedance, which is measured across output terminals of the fuel cell using an alternating current (AC) signal with a predetermined frequency. According to this configuration, the basic internal resistance can be estimated based on the temperature of the fuel cell, the humidity in the fuel cell, or the impedance between the output terminals of the fuel cell.

The calculating unit may have a first correcting unit that corrects the basic internal resistance of the fuel cell based on the output current and the output voltage; and a second correcting unit that corrects the basic output characteristic with the corrected basic internal resistance. According to this configuration, the basic internal resistance of the fuel cell is corrected based on the output current and the output voltage, and the basic output characteristic is corrected. Therefore, the accuracy of the estimation of the basic output characteristic can be improved.

The calculating unit may further have a correction value storing unit that stores the corrected basic internal resistance as a new basic internal resistance; a third correcting unit that further corrects the basic internal resistance based on the output current and the output voltage when a basic internal resistance has been stored in the storing unit; and a fourth correcting unit that corrects the basic output characteristic with the further corrected basic internal resistance. According to this configuration, the corrected basic internal resistance is stored as a new basic internal resistance, and the basic internal resistance is further corrected based on the output current and the output voltage when a basic internal resistance has been stored in the correction value storing unit. Therefore, the accuracy of the estimation of the basic output characteristic.

The detecting unit may have an impedance measuring unit that measures an impedance across output terminals of the fuel cell using an AC signal with a predetermined frequency; and an AC impedance storing unit that stores the measured impedance, and the calculating unit may have a comparing unit that compares the impedance measured by the impedance measuring unit with the impedance measured previously and stored in the impedance storing unit; and an output characteristic correcting unit that corrects the basic internal resistance when the difference between the measured impedance and the previously measured impedance is equal to or greater than a predetermined value as a result of comparison by the comparing unit and corrects the IR-free output characteristic when the difference is smaller than a predetermined value.

According to this configuration, the impedance measured by the measuring unit and an impedance measured previously and stored in the impedance storing unit are compared. The basic internal resistance is corrected when there is a difference equal to or greater than a predetermined value between the measured impedance and the previously measured impedance. The IR-free output characteristic is corrected when there is not such a difference. Therefore, the object to be corrected can be limited and the accuracy of the correction can be improved.

A second aspect of the present invention relates to a method for estimating an output characteristic of a fuel cell. This method includes: detecting a present value of at least one operation parameter that indicates the operating state of the fuel cell; estimating the internal resistance of the fuel cell based on the detected value of the operation parameter with reference to the relation between an internal resistance of the fuel cell excluding both a diffusion resistance of the fuel cell that is generated depending on the flow rate of reaction gas to the fuel cell and a reaction resistance of the fuel cell that is generated depending on the pressure of the reaction gas, and the operation parameter; and setting the estimated internal resistance as a basic internal resistance; measuring the flow rate of air to be supplied to the fuel cell; measuring the pressure of the air; determining an IR-free output characteristic of the fuel cell based on the flow rate and pressure of the air; and setting a basic output characteristic of the fuel cell based on the basic internal resistance and an IR-free output characteristic, which is the relation between the output current and output voltage of the fuel cell, excluding the influence of the internal resistance, at different flow rates and pressures of air to be supplied to the fuel cell. In the above configuration, the method may further include: measuring the output current of the fuel cell and measuring the output voltage of the fuel cell outputting the output current; and correcting the basic output characteristic based on the output current and the output voltage.

The operation parameter may include at least one of temperature of the fuel cell, humidity in the fuel cell, and an impedance, which is measured across output terminals of the fuel cell using an AC signal with a predetermined frequency.

The method may further include: correcting the basic internal resistance of the fuel cell based on the output current and the output voltage; and correcting the basic output characteristic with the corrected basic internal resistance.

The method may further include: storing the corrected basic internal resistance as a new basic internal resistance; correcting the basic internal resistance based on the output current and the output voltage when a basic internal resistance has been stored; and correcting the basic output characteristic with the further corrected basic internal resistance.

The method may further include: measuring an impedance across output terminals of the fuel cell using an AC signal with a predetermined frequency; comparing the measured impedance with a previously measured impedance; and correcting the basic internal resistance when the difference between the measured impedance and the previously measured and stored impedance is equal to or greater than a predetermined value, and correcting the IR-free output characteristic when the difference is smaller than the predetermined value.

BRIEF DESCRIPTION OF THE DRAWINGS

The foregoing and further objects, features and advantages of the invention will become apparent from the following description of preferred embodiments with reference to the accompanying drawings, wherein like numerals are used to represent like elements and wherein:

FIG. 1 is a system configuration diagram of a fuel cell system according to a first embodiment of the present invention.
FIG. 2 is a graph illustrating an example of the relation between cell stack temperature and internal resistance.
FIG. 3 is a graph illustrating an example of the change in current-voltage characteristic at different pressures on the air electrode side.
FIG. 4 is a graph illustrating an example of current-voltage characteristic at different flow rates of air to the fuel cell.
FIG. 5 is a flowchart of a fuel cell system controlling operation according to the first embodiment of the present invention.

FIG. 6 is a system configuration diagram of a fuel cell system according to a second embodiment of the present invention.

FIG. 7 is a graph showing the relation among humidification amount in a fuel cell, fuel cell temperature and internal resistance.

FIG 8 is a flowchart of a fuel cell system controlling operation according to the second embodiment of the present invention.

FIG. 9 is a system configuration diagram of a fuel cell system according to a third embodiment of the present invention.

FIG. 10 is a graph illustrating an example of the relation among airflow rate in a humidifier, temperature of a fuel cell body 1 and amount of humidification.

FIG. 11 is a flowchart of a fuel cell system controlling operation according to the third embodiment of the present invention.

FIG 12 is a chart illustrating an example of AC impedance.

FIG. 13 is a flowchart of a fuel cell system controlling operation according to the fourth embodiment of the present invention.

FIG. 14 is a graph illustrating an example of the result of measurement of the relation between AC impedance and internal resistance at different amounts of humidification to air.

FIGS. 15A and 15B are flowcharts of a fuel cell system controlling operation according to the fifth embodiment of the present invention.

FIGS. 16A and 16B are flowcharts of a fuel cell system controlling operation according to the sixth embodiment of the present invention.

DETAILED DESCRIPTION OF PREFERRED EMBODIMENTS

Description is hereinafter made of fuel cell systems according to the best modes for carrying out the present invention (which are hereinafter referred to as "embodiments") with reference to the drawings. The configurations of the embodiments are illustrative, and the present invention is not limited to the configurations of the embodiments.

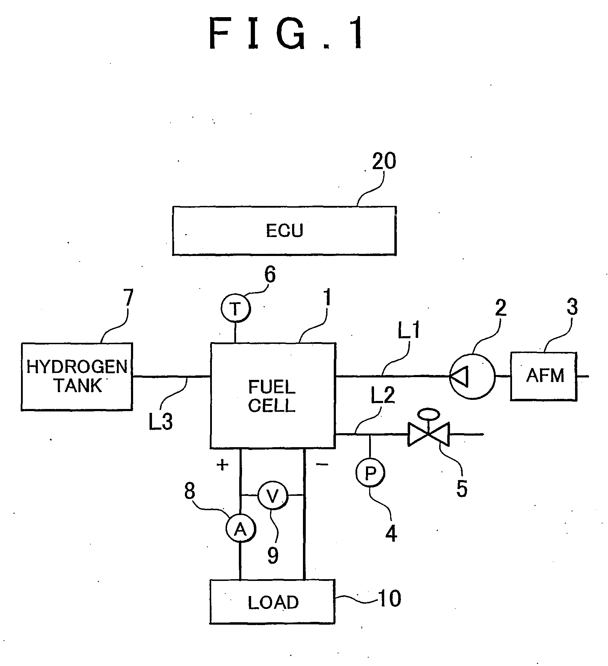

FIG. 1 is a system configuration diagram of a fuel cell system according to a first embodiment of the present invention. The fuel cell system has a fuel cell body 1 including a cell stack in which unit cells are stacked; an air compressor 2 that supplies air to the air electrode side in the fuel cell body 1 through an air supply passage L1; an airflow meter 3 (which may be regarded as a flow rate measuring unit) that measures the flow rate of the air supplied from the air compressor 2 to the fuel cell body 1; a pressure sensor 4 (which may be regarded as a pressure measuring unit) that measures the gas pressure on the air electrode side via a discharge passage L2 on the air electrode side of the fuel cell body 1; a pressure control valve 5 that controls the gas pressure on the air electrode side including the discharge passage L2; a hydrogen tank 7 from which hydrogen is supplied to the hydrogen electrode side in the fuel cell body 1 through a hydrogen supply passage L3; a current sensor 8 (which may be regarded as an output current measuring unit) and a voltage sensor 9 (which may be regarded as an output voltage measuring unit) that measure the current and voltage, respectively, to be supplied to a load 10 connected to output terminals of the fuel cell body 1; a temperature sensor 6 (which may be regarded as a detecting unit) that measures the temperature of the fuel cell body 1 (the temperature of the cell stack); and an electronic control unit (ECU) 20 that monitors the state of every part of the fuel cell system and controls the entire fuel cell system. Each of the components constituting the fuel cell system is well known and hence their description is omitted.

In the fuel cell system shown in FIG. 1, the ECU 20 has the following functions. (1) The ECU 20 determines an internal resistance of the fuel cell body 1 based on the temperature of the cell stack of the fuel cell body 1. The internal resistance is the resistance that causes a voltage drop in the fuel cell body 1 when an output current is supplied from the fuel cell body 1 to the load 10. Examples of the causes of the internal resistance include the resistance that is generated when protons are conducted through a polymer electrolyte membrane in the fuel cell body 1 and the resistance that is generated when electrons are conducted through a separator.

In this embodiment, the ECU 20 has a memory (which may be regarded as an operation parameter storing unit), in which the relation between the cell stack temperature and the internal resistance, which was measured experimentally in advance, is stored as a map. Therefore, the ECU 20 can detect the cell stack temperature and determine the internal resistance by monitoring the output signal from the temperature sensor 6. The internal resistance, which is determined based on the cell stack temperature according to the map stored, is referred to as "basic internal resistance R0."

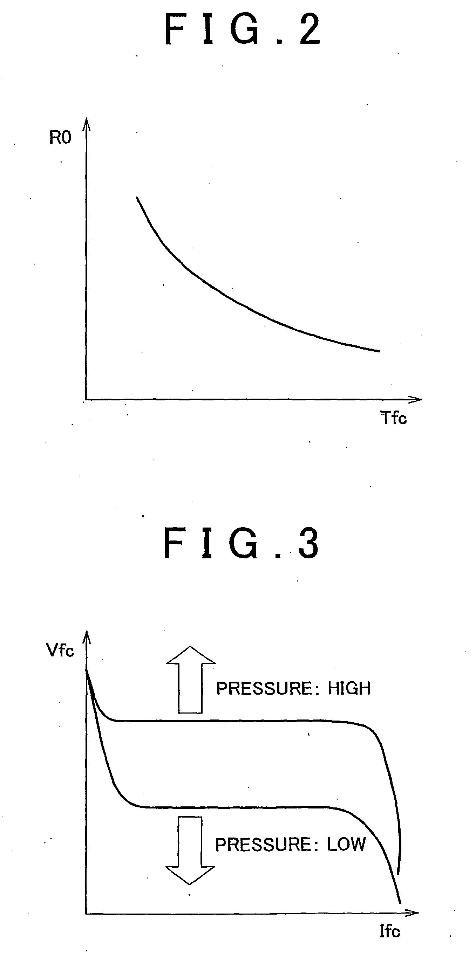

FIG. 2 shows an example of the relation between the cell stack temperature Tfc and the internal resistance R0. In general, the internal resistance of a fuel cell decreases monotonously with increase in the cell stack temperature Tfc. This is because the internal resistance of a fuel cell is determined primarily by the travel speed of the active material (protons in a polymer electrolyte membrane type fuel cell) and, in general, the travel speed of protons is higher and the internal resistance is lower when the temperature is higher.

(2) The ECU 20 determines the IR-free output characteristic of the fuel cell body 1 based on the pressure on the air electrode side in the fuel cell body 1 and the airflow rate to the air electrode. The IR-free output characteristic of the fuel cell body 1 is also measured experimentally in advance and stored in the memory (which may be regarded as an output characteristic storing unit) of the ECU 20 as a map.

Such a map may be obtained by, for example, the following procedure. The output characteristic, that is, the relation between the output current and the output voltage of the fuel cell, is measured with the pressure on the air electrode side and the airflow rates to the air electrode varied in advance by an experiment. Then, the internal resistance of the fuel cell is estimated based on the current cell stack temperature according to a map of the relation between the cell stack temperature and the internal resistance as shown in FIG. 2, for example. Finally, an IR-free output characteristic is obtained by subtracting a voltage drop caused by the estimated internal resistance from the measured output characteristic. As described above, the IR-free output characteristic is calculated using the pressure on the air electrode side and the airflow rate to the air electrode as operation parameters.

FIG. 3 shows an example of the change in current-voltage characteristic at different pressures on the air electrode side. As is well known, the current-voltage characteristic of the fuel cell body 1 forms a downward-sloping curve when plotted on a graph with the horizontal axis as the output current Ifc and the vertical axis as the output voltage Vfc. In the example shown in FIG. 3, however, the output voltage Vfc is generally constant in the middle part of the graph, regardless of the change in the output current Ifc because the internal resistance of the fuel cell body 1 is excluded.

If the output current Ifc exceeds a certain limit, the output voltage Vfc drops rapidly. This is because insufficient reaction gas to generate the output current Ifc is supplied, and therefore the gas diffusion resistance, which is generated when gas is diffused in the electrodes, appears prominently as a resistance value. When the amount of reaction gas (the airflow rate on the air electrode side, for example) is sufficiently large to generate the output current Ifc, the influence of the reaction gas diffusion resistance is small and the drop of the output voltage is small.

Also, it is known that even when the air is supplied at the same flow rate, as the pressure on the air electrode side is higher, the output voltage Vfc corresponding to an output current Ifc is higher as shown in FIG. 3. That is, the pressure of gas supplied to a fuel cell has a large influence on the electrode reaction activity, and, as the gas pressure increases, the efficiency of the reaction with a catalyst (not shown) in the fuel cell body 1 also increases. When the gas pressure is low, the efficiency of the reaction with a catalyst is low and the output voltage Vfc is low. Therefore, the current-voltage characteristic of the fuel cell body 1 exhibits a curve which is separated vertically in two different voltage values in the middle depending on the pressure on the air electrode side as shown in FIG. 3.

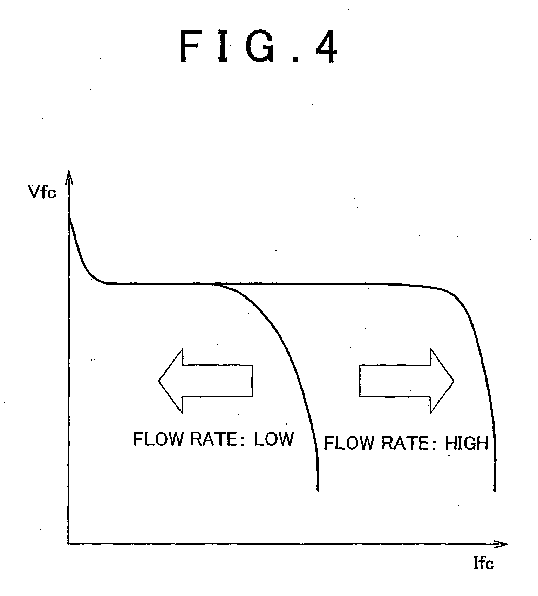

FIG. 4 shows an example of the current-voltage characteristic, which is obtained when the airflow rate to the air electrode is varied while the gas pressure on the air electrode in the fuel cell body 1 is maintained constant.

As shown in FIG. 4, when the airflow rate is high, the output voltage Vfc does not drop until the output current Ifc reaches the present value corresponding to the air supply amount. When the airflow rate is low, the output voltage Vfc drops rapidly when the output current Ifc reaches a low present value corresponding to the air supply amount. This is because the limit present value and the gas diffusion resistance vary depending on the flow rate of the gas that is supplied to the fuel cell.

That is, when the airflow rate is low, the limit present value is low. Then, the influence of the gas diffusion resistance (which is referred to as concentration polarization) appears in a small present value region and the IR-free voltage Virf(Ifc) drops. This is because, the airflow rate is not so high as to correspond to the output current Ifc value, and therefore the effect of the gas diffusion resistance increases. Thus, the current-voltage characteristic of the fuel cell body 1 exhibits a curve which bifurcates depending on the value of the output current Ifc as shown in FIG. 4.

(3) The ECU 20 estimates the current-voltage characteristic of the fuel cell body 1 including the internal resistance at that instant from the relation between the basic internal resistance R0 and the IR-free output characteristic obtained as described in (1) and (2), respectively. The current-voltage characteristic is referred to as "basic output characteristic" in this embodiment.

The ECU 20 then calculates the correction amount $\Delta R$ for correcting the basic internal resistance R0 based on the difference in the output current and output voltage actually measured by the current sensor 8 and the voltage sensor 9, respectively, and the basic output characteristic to obtain a corrected internal resistance R1 = R0 + $\Delta R$. Then, the ECU 20 newly sets a current-voltage characteristic using the corrected internal resistance R1. The thus set current-voltage characteristic is used as a reference to set the amount of reaction gas that is supplied, or other operations with respect to the amount of electric power demanded from the fuel cell body 1. The ECU 20 repeatedly performs the above processes (1) to (3) at predetermined intervals.

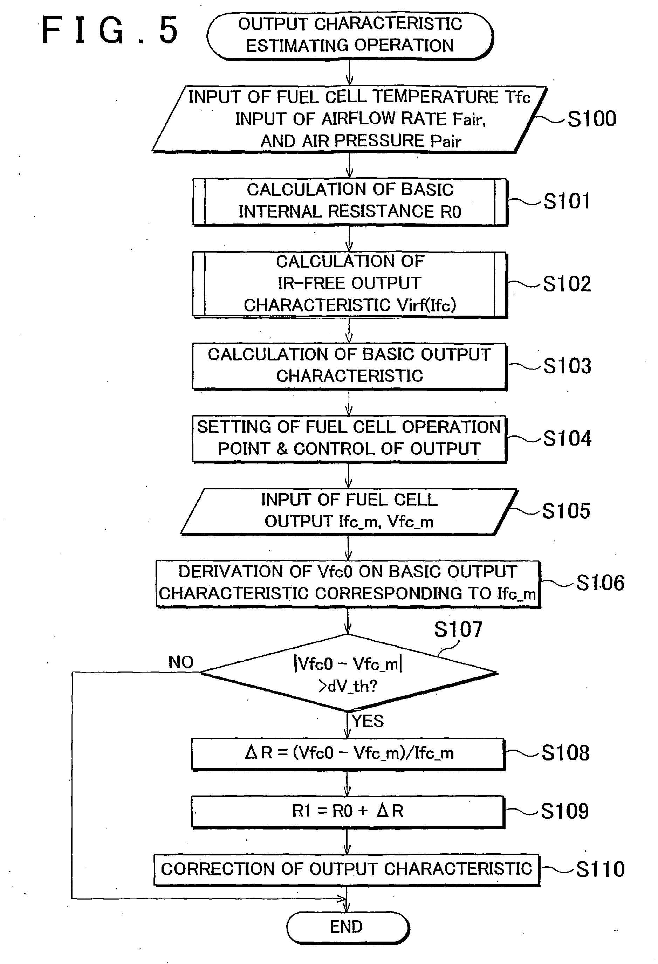

FIG. 5 shows a flowchart of the fuel cell system controlling operation performed by the ECU 20. In FIG. 5, the output characteristic estimating operation, in particular, is shown in detail together with the fuel cell system controlling operation. In this operation, the ECU 20 first reads the temperature Tfc of the fuel cell body 1 from the temperature sensor 6 (S100). The ECU 20 also reads the airflow rate Fair from the airflow meter 3. In addition, the ECU 20 reads the air pressure Pair from the pressure sensor 4.

The ECU 20 then calculates a basic internal resistance R0 based on the temperature Tfc of the fuel cell body 1 (S101: the ECU 20, which performs this step, may be regarded as an internal resistance estimating unit). Then, the ECU 20 calculates an IR-free output characteristic Virf(Ifc), which is measured in advance based on the airflow rate Fair and the air pressure Pair (S102:

the ECU 20, which performs this step, may be regarded as a determining unit). The Virf(Ifc) is the function representing the relation between the output current Ifc and the IR-free voltage Virf, and may be represented as pairs of an output current Ifc and an IR-free voltage Virf, for example. The relation between the output current Ifc and the IR-free voltage Virf may, however, be represented as an experimental formula.

The ECU 20 then calculates the basic output characteristic (S103: the ECU 20, which performs this step, may be regarded as a setting unit). The basic output characteristic is calculated by adding the effect of the basic internal resistance R0 to the above IR-free output characteristic, to be derived as Virf(Ifc) - Ifc $\times$ R0.

The ECU 20 then determines an operation point (Ifc, Vfc) on the basic output characteristic Virf(Ifc) - Ifc $\times$ R0 based on the output demanded to the fuel cell system, and controls the voltage across the output terminals of the fuel cell body 1 to Vfc (S104). More specifically, the ECU 20 controls the voltage across the output terminals to Vfc via a DC-DC converter (not shown), for example. At this time, when the amount of reaction gas (hydrogen or air) corresponding to the output of the fuel cell is not supplied to the fuel cell and therefore insufficient, the current decreases. Thus, although not shown in FIG. 5, the ECU 20 determines the necessary amount of reaction gas based on the electric power demanded of the fuel cell and determines an operation point based on the current-voltage characteristic at the reaction gas amount.

The ECU 20 then reads the actual output current Ifc_m and output voltage Vfc_m of the fuel cell from the current sensor 8 and the voltage sensor 9, respectively (S105). Then, the ECU 20 derives a value Vfc0 = Virf(Ifc_m) - Ifc_m $\times$ R0 on the basic output characteristic corresponding to the output current Ifc_m (S106). When the IR-free output characteristic Virf(Ifc) is given as an experimental formula, for example, the value is obtained by adding the voltage drop caused by the basic internal resistance R0 to a value calculated using the formula. When the IR-free output characteristic Virf(Ifc) is given with a plurality of current-voltage pairs (I, V), the value is obtained by adding the voltage drop caused by the basic internal resistance R0 to the output voltage value at the time when I = Ifc_m obtained by interpolation.

The ECU 20 then determines whether the difference between the output voltage Vfc0 obtained from the basic output characteristic and the output voltage Vfc_m obtained from the voltage sensor 9 is within a predetermined range (S107). When it is determined that the difference is not within the predetermined range and there is a large difference, the ECU 20 corrects the basic output characteristic as follows to obtain a new output characteristic.

That is, the ECU 20 calculates a correction value for the basic internal resistance R0 according to the equation $\Delta R = (Vfc0 - Vfc\_m)/Ifc\_m$ (S108). Then, the ECU 20 corrects the basic internal resistance R0 according to the equation R1 = R0 + $\Delta R$ to obtain a new internal resistance R1 (S109: the ECU 20, which performs this step, may be regarded as a first correcting unit).

Also, the ECU 20 calculates an output characteristic Vfc(Ifc) = Virf(Ifc) - R1 $\times$ Ifc using the newly obtained internal resistance R1 (S110: ECU 20, which performs this step, may be regarded as a calculating unit and a second correcting unit).

As described above, according to the fuel cell system of the embodiment, the changes in the limit present value and in the gas diffusion resistance caused by change in the airflow rate and the change in the reaction resistance caused by changes in the air pressure are reflected in the basic output characteristic. Therefore, an output characteristic in which the changes in the airflow rate and the air pressure are reflected is estimated, and an output characteristic may be estimated with higher accuracy.

In the above embodiment, the detected internal resistance difference value $\Delta R$ is used as it is as a correction value for the internal resistance as shown in step S109 in FIG. 5. However, the present invention is not limited to this method. That is, to avoid a sudden change caused by the correction of the internal resistance as shown in FIG. 5, a filtering process may be performed to slow the change in the value after obtaining a new resistance R1. Also, the correction amount $\Delta R$ may be distributed to a proportional term and an integral term as in the equation shown below, and a PI control with proportional and integral actions may be performed.

$$R1 = R0 + Kp \times \Delta R + Ki \times \int^{T} \Delta R dt;$$

where, Kp and Ki are the proportional gain and the integral gain, respectively.

Also, in the flowchart shown in FIG. 5, a basic internal resistance R0 is obtained in S101 and the internal resistance R1 of the fuel cell is corrected from the basic internal resistance R0 in S109. However, the operation of the present invention is not limited to the procedure. When the internal resistance R1 is obtained from the basic internal resistance R0, the internal resistance R1 may be stored in the memory of the ECU 20. Then, in the next and subsequent operations, the ECU 20 may sequentially correct the internal resistance R1 using the difference between the stored internal resistance R1 and the internal resistance actually measured from the output current and the output voltage.

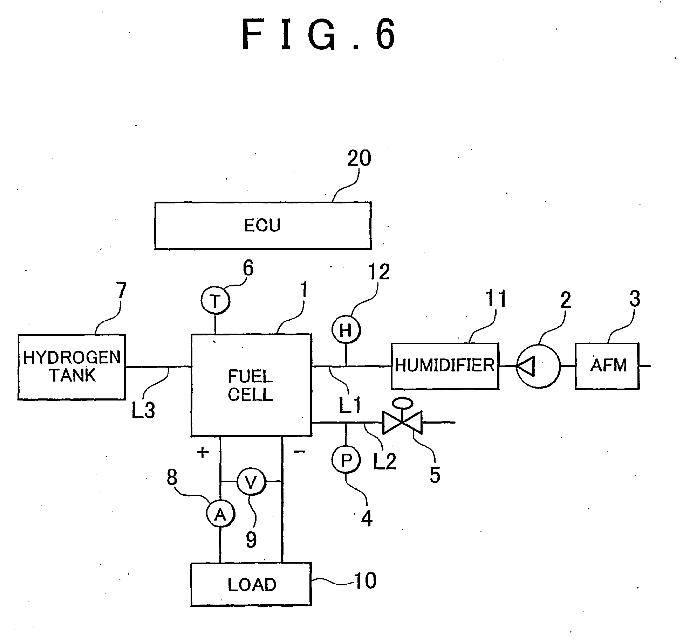

Referring to FIG. 6 to FIG. 8, a second embodiment of the present invention is described. In the first embodiment, a basic output characteristic is estimated based on the air pressure on the air electrode side and the airflow rate to be supplied to the air electrode, and the basic output characteristic is corrected using actually detected output current and output voltage to obtain an output characteristic of the fuel cell. Also in the first embodiment, the basic internal resistance included in the basic output characteristic is determined based on the temperature of the fuel cell body 1. In this embodiment, a fuel cell system is described in which the humidification amount in the fuel cell body 1 is reflected in determining a basic internal resistance. The other configuration and function of this embodiment are the same as those of the first embodiment. The same components are therefore denoted by the same reference numerals, and their description is not repeated.

FIG. 6 shows a fuel cell system of this embodiment. The fuel cell system differs from the fuel cell system of the first embodiment in that a humidifier 11 and a humidity sensor 12 (which may be regarded as a detecting unit) are added downstream of the air compressor 2, that is, on the side near the fuel cell body 1, on the air supply passage L1.

The ECU 20 has a map of the relation between the temperature Tfc and the internal resistance of the fuel cell body 1 with the amount of humidification to the fuel cell body 1 as a parameter in the memory. Here, the humidification amount is the humidity that is measured when the air is humidified. Therefore, the ECU 20 obtains an air humidification amount Sair from a detection signal from the humidity sensor 12 and the temperature Tfc of the fuel cell body 1 from a detection signal from the temperature sensor 6. Then, the ECU 20 calculates a basic internal resistance R0 based on the humidification amount Sair and the temperature Tfc.

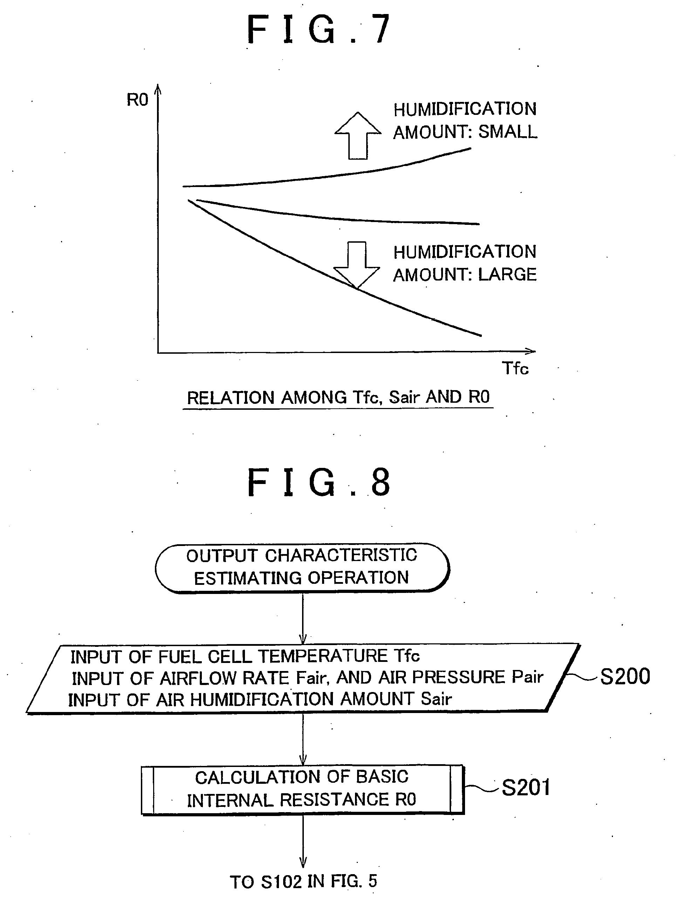

FIG. 7 is a graph showing the relation among the humidification amount, the fuel cell temperature Tfc and the internal resistance that the ECU 20 has in the memory. The internal resistance of a polymer electrolyte membrane fuel cell is dependent on the travel speed (conductivity) of the active material (protons). The conductivity of protons through a polymer electrolyte membrane is dependent on the water content of the polymer electrolyte membrane and the temperature of the membrane. The water content of a polymer electrolyte membrane is changed by the influence of the humidity of the gas supplied.

When the temperature of the fuel cell body 1 is high, because the temperature of the polymer electrolyte membrane is high and the temperature of air supplied at this time is also high, the saturated vapor pressure of the air is high. Therefore, the change in the amount of humidification to the air has a large influence on the amount of water in the polymer electrolyte membrane. Thus, as shown in FIG. 7, the internal resistance varies largely depending on the amount of humidification to the air on the high temperature side.

When the temperature of the fuel cell body 1 is low, because the temperature of air supplied at this time is low, the saturated vapor pressure of the air is low. Therefore, changing the amount of humidification to the air has less influence on the amount of water in the polymer electrolyte membrane than at high temperatures.

Thus, as shown in FIG. 7, the change in the internal resistance caused by the difference in the amount of humidification to the air is small on the low temperature side.

Also, as shown in FIG 7, when the humidity of the gas is low, the polymer electrolyte membrane tends to get dry when the temperature of fuel cell body 1 increases. In this case, the internal resistance increases accordingly. When the humidity is high, the polymer electrolyte membrane is unlikely to become dry even when the temperature of the fuel cell body 1 is high. In this case, the travel speed of protons increases because of the increase in the temperature and the internal resistance decreases as shown in FIG. 2.

FIG. 8 shows a flowchart of the fuel cell system controlling operation performed by the ECU 20. In this operation, the ECU 20 first reads the temperature Tfc of the fuel cell body 1 from the temperature sensor 6 (S200). The ECU 20 also reads the airflow rate Fair from the airflow meter 3. In addition, the ECU 20 reads the air pressure Pair from the pressure sensor 4. Further, the ECU 20 reads the air humidification amount Sair from the pressure sensor 4.

The ECU 20 then calculates a basic internal resistance R0 based on the temperature Tfc of the fuel cell body 1 and the humidification amount Sair (S201). The subsequent steps are the same as those in and after S102 in FIG. 5.

As described above, in the fuel cell system of this embodiment, a basic internal resistance R0, which is attributed to the proton conductivity of the membrane, is estimated from the fuel cell temperature Tfc and the air humidification amount Sair. That is, the humidification degree of the air is reflected in the estimation of the basic internal resistance R0. Therefore, the output characteristic may be estimated with higher accuracy than in the system of the first embodiment.

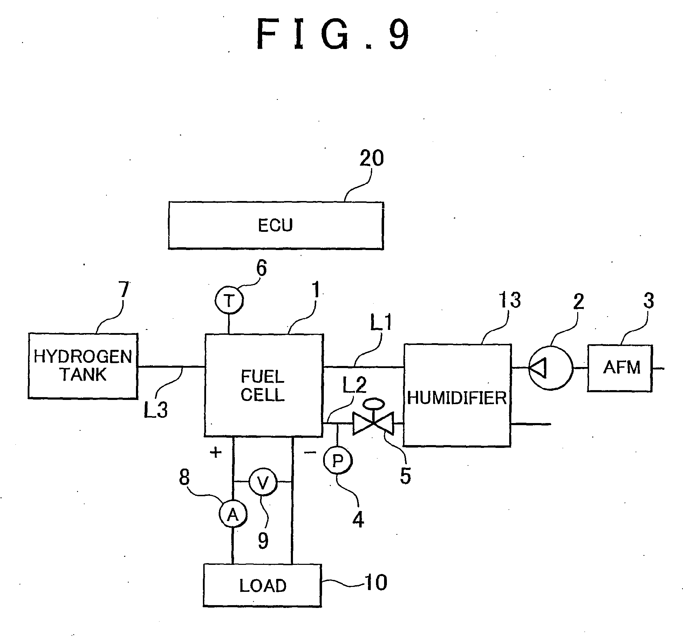

Referring to FIG 9 to FIG. 11, a third embodiment of the present invention is described. In the second embodiment, the air humidification amount is obtained from a detection signal from the humidity sensor 12 and used to estimate a basic internal resistance R0. In this embodiment, a fuel cell system is described in which the air humidification amount is obtained based the airflow rate flowing through a humidifier and the fuel cell temperature, instead of from a detection signal from the humidity sensor 12, and used to estimate a basic internal resistance R0. The other configuration and function of this embodiment are the same as those of the second embodiment. The same components are therefore denoted by the same reference numerals, and their description is not repeated.

FIG. 9 shows a fuel cell system of this embodiment. As compared to the fuel cell system of the second embodiment, the fuel cell system does not have the humidity sensor 12. Also, the fuel cell system has a water vapor exchange membrane type humidifier 13, with a water vapor exchange membrane that humidifies air, instead of the humidifier 11 in FIG 6. The water vapor exchange membrane type humidifier returns the water vapor (generated water) in the off gas discharged through the discharge passage L2 on the air electrode side to the air supply passage L1 on the upstream side through an exchange membrane therein.

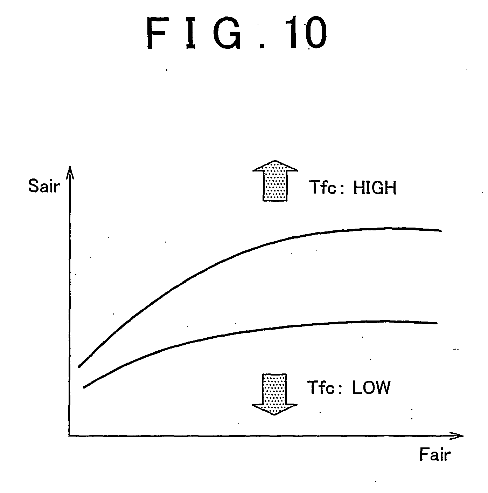

FIG. 10 shows an example of the relation among the airflow rate Fair in the water vapor exchange membrane type humidifier 13, the temperature Tfc of the fuel cell body 1 and the humidification amount Sair. Here, the airflow rate Fair is the flow rate in the air supply passage L1 on the upstream side.

In general, the humidification amount Sair increases as the airflow rate Fair in the air supply passage L1 increases in the water vapor exchange membrane type humidifier 13 as shown in FIG. 10. However, the rate of increase in the humidification amount Sair gradually decreases as the airflow rate Fair increases, and the humidification amount Sair is saturated in the high flow rate region. Also, when the fuel cell temperature Tfc is high, the saturated vapor pressure of the air increases and the humidification amount increases.

When the fuel cell temperature Tfc is low, the saturated vapor pressure of the air decreases and the humidification amount decreases as compared when the fuel cell temperature Tfc is high. Therefore, the relation among the airflow rate Fair, the temperature Tfc of the fuel cell body 1, and the humidification amount Sair is stored in advance as a map in the memory of the ECU 20 so that the humidification amount Sair can be calculated based on the results of measurement of the airflow rate Fair and the temperature Tfc of the fuel cell body 1.

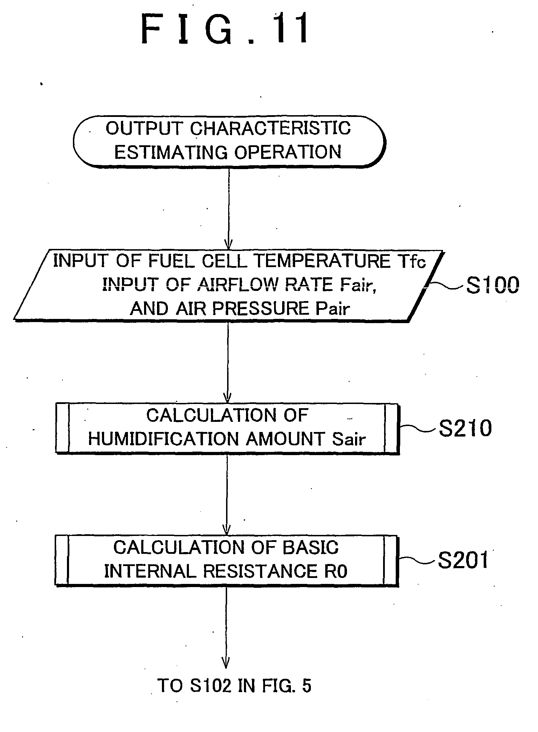

FIG. 11 shows a flowchart of the fuel cell system controlling operation performed by the ECU 20. In this operation, the ECU 20 reads the temperature Tfc of the fuel cell body 1, the airflow rate Fair, and the air pressure Pair (S100). This step is the same as S100 of the first embodiment shown in FIG. 5.

The ECU 20 then calculates the air humidification amount Sair based on the temperature Tfc of the fuel cell body 1 and the airflow rate Fair according to the map stored in the memory (S210).

The ECU 20 then calculates a basic internal resistance R0 based on the temperature Tfc of the fuel cell body 1 and the humidification amount Sair (S201). The subsequent steps are the same as those in and after S102 in FIG. 5.

As described above, in the fuel cell system of this embodiment, the air humidification amount Sair can be obtained from the temperature Tfc of the fuel cell body 1 and the airflow rate Fair without the humidity sensor 12. Therefore, the fuel cell system is advantageously applicable to a vehicle or the like which is required to have a long service life because the humidity sensor 12 is unnecessary.

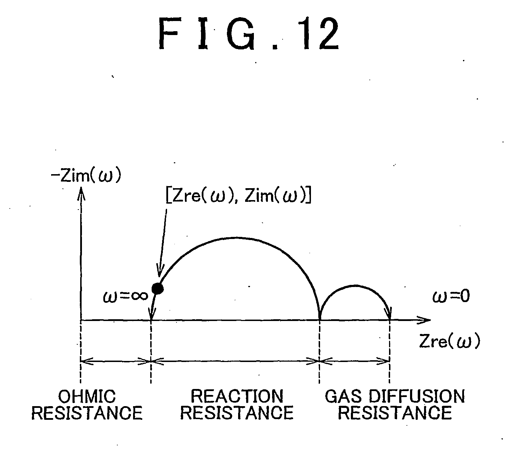

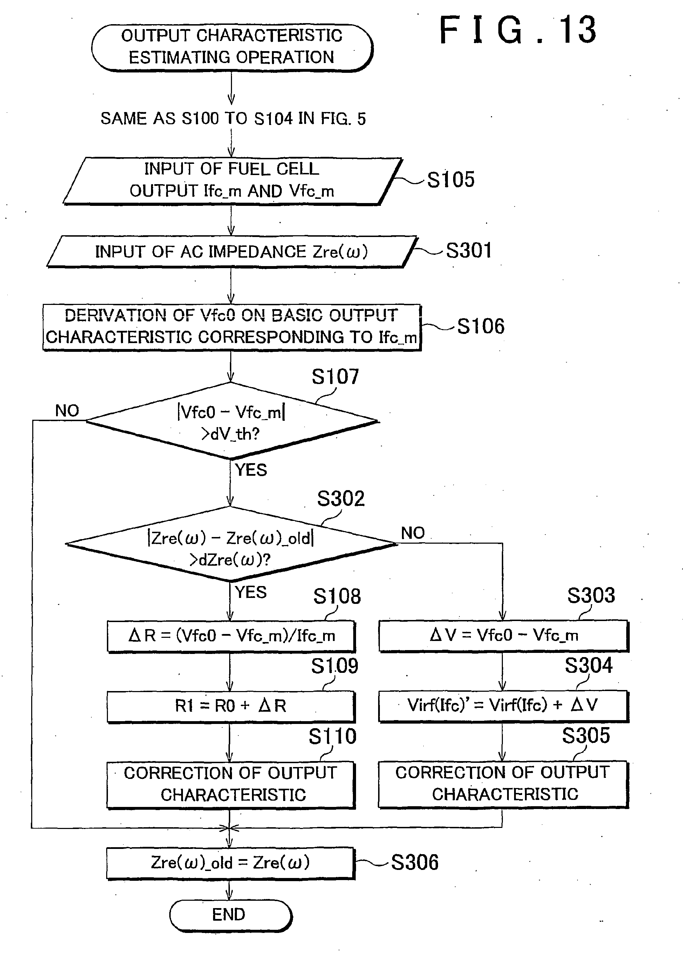

Referring to FIG. 12 and FIG. 13, a fourth embodiment of the present invention is described. In the first to third embodiments, a basic internal resistance R0 of the fuel cell body 1 is estimated based on the temperature of the fuel cell body 1 or the air humidification amount, and the output current and the output voltage are measured to correct the basic internal resistance R0.

In the fourth embodiment, a fuel cell system is described in which an AC signal is input into the output terminals of the fuel cell body 1 and the necessity of correcting the basic internal resistance R0 is estimated based on the impedance between the output terminals. The other configurations and functions are the same as those of the first embodiment. The same components as those of the first to third embodiments are therefore denoted by the same reference numerals, and their description is not repeated.

As a method for measuring an internal resistance of a fuel cell, a method in which an AC impedance of a fuel cell is measured is disclosed in, for example, JP-A-2003-297408. The AC impedance of the fuel cell may be obtained by frequency analysis of the current and voltage, which are measured with a sine wave superimposed on the output current (or output voltage) of the fuel cell.

FIG 12 shows an example of the AC impedance of a fuel cell. It is known that the AC impedance may be divided by frequency into regions each reflecting the gas diffusion resistance, the reaction resistance, and the ohmic resistance as shown in FIG. 12. It is also known that the frequency $\omega$ can be regarded as infinite ($\omega = 8$) in the region of approximately 1 kHz or higher as shown in FIG 12 and the real part of the AC impedance is generally equal to the ohmic resistance.

The ohmic resistance in this case is generally attributed to the resistances of the polymer electrolyte membrane and the separator part and constitutes a primary element of the internal resistance of the fuel cell. Thus, by monitoring whether the ohmic resistance fluctuates, it can be known whether the internal resistance fluctuates.

FIG. 13 shows a flowchart of the fuel cell system controlling operation performed by the ECU 20. In this operation, the ECU 20 first performs the same steps as S100 to S104 shown in FIG. 1 to determine the basic internal resistance R0 and the basic output characteristic of the fuel cell and controls the fuel cell body 1 to a predetermined operation point. Here, the basic internal resistance R0 may be the internal resistance, which is estimated based on operation parameters of the fuel cell (such as the temperature of the fuel cell body 1 and the air humidification amount) according to a map stored in advance.

The ECU 20 then reads the actual output current Ifc_m and output voltage Vfc_m of the fuel cell from the current sensor 8 and the voltage sensor 9, respectively (S105).

The ECU 20 then measures an AC impedance and obtains the real part $Zre(\omega)$ of the AC impedance (S301: the ECU 20, which performs this step, may be regarded as a detecting unit and an AC impedance measuring unit). The real part of the AC impedance is hereinafter referred to simply as "AC impedance" in this embodiment.

The ECU 20 then derives a value Vfc0 = Virf (Ifc_m) - Ifc_m × R0 on the basic output characteristic corresponding to the output current Ifc_m (S106).

The ECU 20 then determines whether the difference between the output voltage Vfc0 obtained from the basic output characteristic and the output voltage Vfc_m obtained from the voltage sensor 9 is within a predetermined range (S107). When it is determined that the difference is not within the predetermined range and there is a large difference, the ECU 20 corrects the basic output characteristic as follows to obtain a new output characteristic.

That is, the ECU 20 compares the AC impedance Zre(ω) obtained in S301 and an AC impedance Zre(ω)_old measured in the previous time and determines whether their difference is within a predetermined range (S302: the ECU 20, which performs this step, may be regarded as a comparing unit). If it is determined that the difference is not within the predetermined range and there is a large difference, the ECU 20 determines that the internal resistance of the fuel cell has changed to a value different from the basic internal resistance R0 and corrects the internal resistance and the output characteristic as in the case shown in FIG. 1 (S108 to S110).

When it is determined in S302 that the difference between the AC impedances is within the predetermined range and there is only a small change, it is determined that the IR-free output characteristic has changed. Then, the ECU 20 calculates the difference ΔV between the output voltage Vfc0 obtained based on the basic output characteristic and the actual output voltage Vfc_m measured by the voltage sensor 9 (S303).

Then, the ECU 20 corrects the IR-free output characteristic according to the following equation shown below (S304).

$$Virf' = Virf + \Delta V;$$

The ECU 20 then obtains an output characteristic of the fuel cell based on the corrected IR-free output characteristic (S305).

$$Vfc(If) = Virf'(If) + R0 \times If;$$

After the above process, the ECU 20 stores the measured AC impedance as the AC impedance measured in the previous time (S306: the ECU 20, which performs this step, may be regarded as an impedance storing unit). After that, the ECU 20 ends the output characteristic estimating operation. The ECU 20, which performs steps S108 to S110 or S303 to S305 may be regarded as an output characteristic correcting unit.

As described above, according to the fuel cell system of this embodiment, it is determined whether the difference between the basic output characteristic and the current-voltage characteristic actually measured is attributed to the internal resistance or the IR-free output characteristic, and the output characteristic of the fuel cell is estimated. Therefore, the output characteristic of the fuel cell can be estimated with higher accuracy than in the first embodiment. As a result, because the accuracy of an IR-free output characteristic, which is obtained in advance, is allowed to include some degree of error, the number of steps to obtain it can be significantly reduced.

The internal resistance R1 corrected in S109 in FIG. 13 may be stored in the memory of the ECU. 20. In this case, the output characteristic may be obtained using the corrected internal resistance R1 instead of the basic internal resistance R0 in S305 when the corrected internal resistance R1 has been already stored. That is, output characteristic may be corrected using the following equation.

$$Vfc(If) = Virf'(If) + R1 \times If;$$

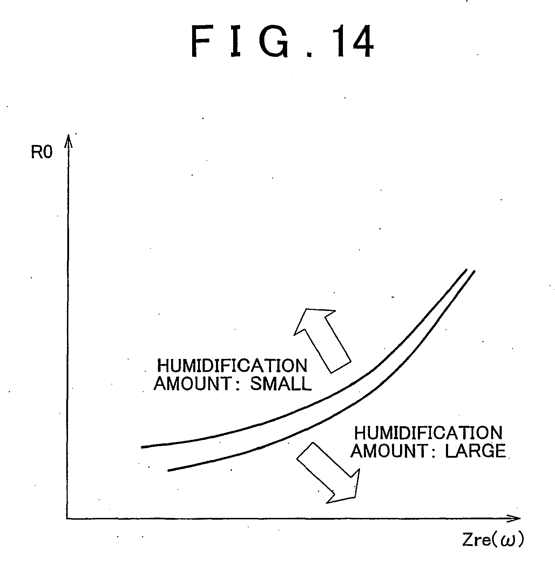

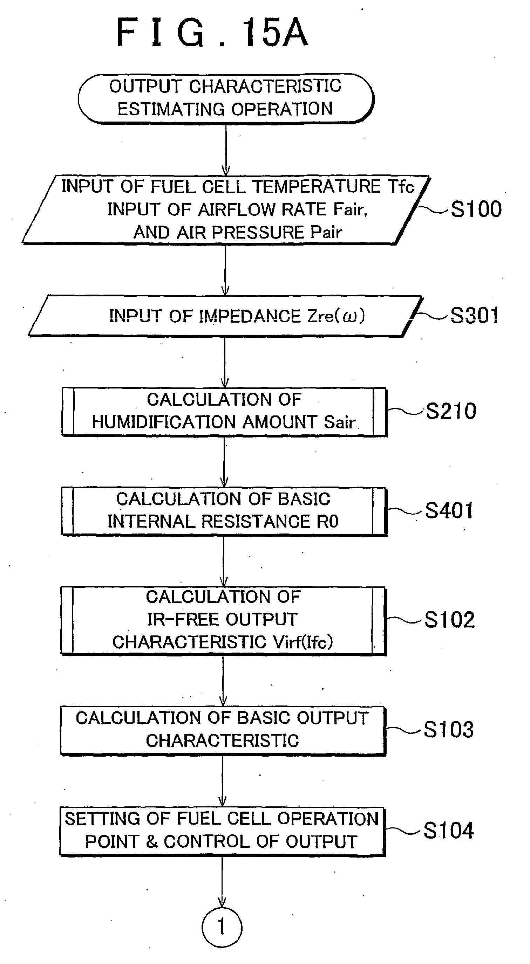

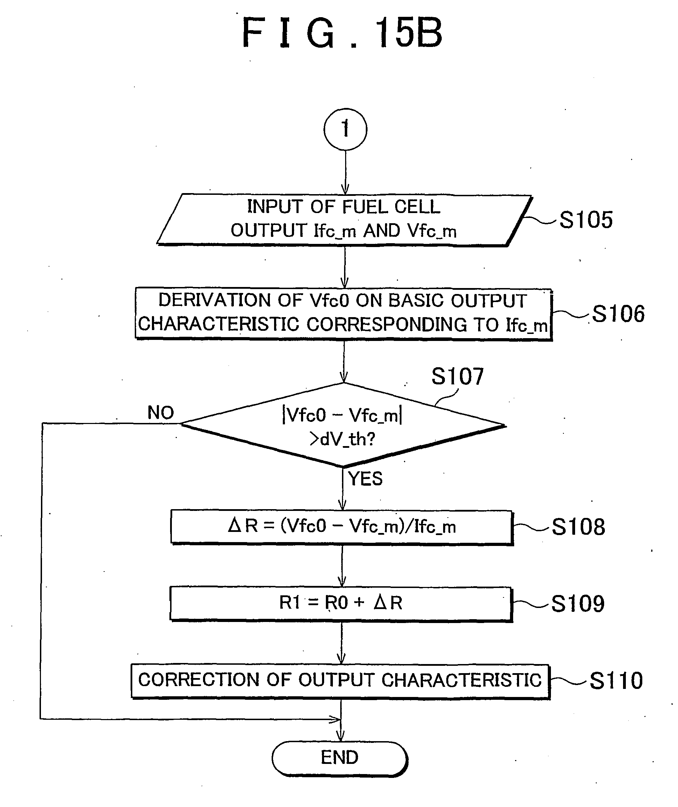

Referring to FIG. 14 and FIG. 15, a fifth embodiment of the present invention is described. In the second embodiment, a basic internal resistance R0 of the fuel cell body 1 is estimated based on the temperature of the fuel cell body 1 and the air humidification amount. In the fourth embodiment, it is determined whether the basic internal resistance R0 should be corrected or the basic output characteristic should be corrected based on the variation in the AC impedance of the fuel cell. In this embodiment, a fuel cell system is described in which a basic internal resistance R0 is estimated based on the air humidification amount and the AC impedance of the fuel cell. The other configuration and function of this embodiment are the same as those of the first embodiment. The same components as those of the first embodiment are therefore denoted by the same reference numerals, and their description is not repeated.

FIG. 14 shows an example of the result of measurement of the relation between the AC impedance (ohmic resistance) and the internal resistance at different amounts of humidification to the air. As shown in FIG. 14, the internal resistance is usually higher at lower humidity. The internal resistance may be measured by, for example, the same method as in the first embodiment, and the AC impedance may be measured by the same method as in the fourth embodiment. That is, the temperature of the fuel cell body 1, the air humidification amount, and the AC impedance are first measured, and a basic internal resistance R0 is obtained based on the temperature of the fuel cell body 1 and the humidification amount according to FIG. 7. At this time, the AC impedance under the same temperature and humidification amount conditions is obtained. Then, the relation between the basic internal resistance R0 and the AC impedance can be plotted.

In this embodiment, the relation among the humidification amount, the AC impedance and the basic internal resistance R0 is stored in advance as a map in the memory of the ECU 20. Then, the basic internal resistance R0 is determined based on the results of measurement of the humidification amount and the AC impedance.

FIG. 15 shows a flowchart of the fuel cell system controlling operation performed by the ECU 20. In this operation, the ECU 20 reads the temperature Tfc of the fuel cell body 1, the airflow rate Fair, and the air pressure Pair (S100). This step is the same as that of the first embodiment shown in FIG. 5.

The ECU 20 then measures the AC impedance Zre(ω) of the fuel cell. This step is the same as S301 of the fourth embodiment shown in FIG. 13.

The ECU 20 then calculates the humidification amount Sair based on the flow rate from the humidity sensor or the humidifier (S210). The ECU 20 then refers a basic internal resistance R0 from the map (see FIG. 14) based on the AC impedance Zre(ω) and the humidification amount. The subsequent steps are the same as those in and after S102 in FIG. 5.

As described above, in this embodiment, a basic internal resistance R0 is determined from the AC impedance of the fuel cell and the air humidification amount with reference to a map of the relation among the AC impedance, the air humidification amount and the basic internal resistance R0. Therefore, the output characteristic of the fuel cell may be estimated with higher accuracy than in the second embodiment, in which the basic internal resistance R0 is determined simply from the humidification amount. Also, the output characteristic of the fuel cell may be estimated with higher accuracy than in the fourth embodiment, in which a measurement value of the AC impedance is used to determine whether the internal resistance has changed.

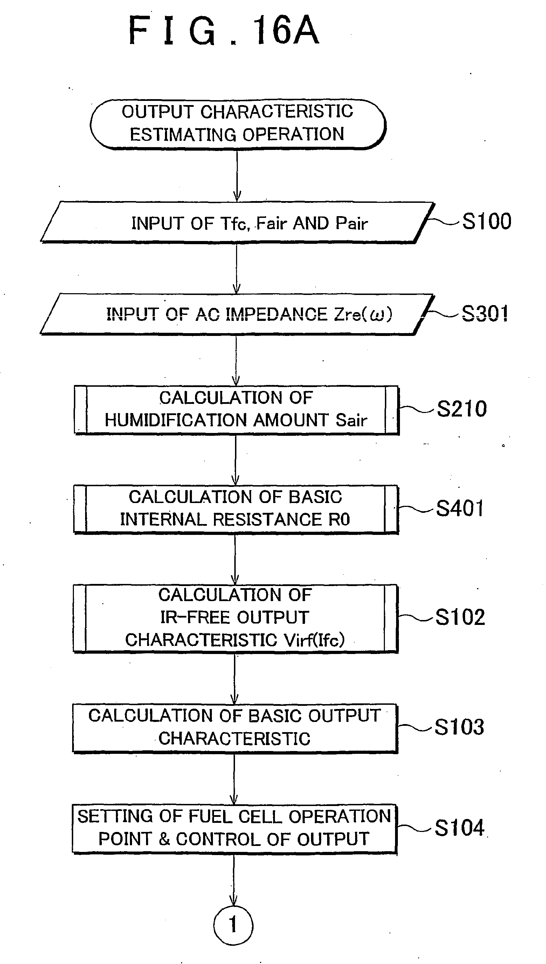

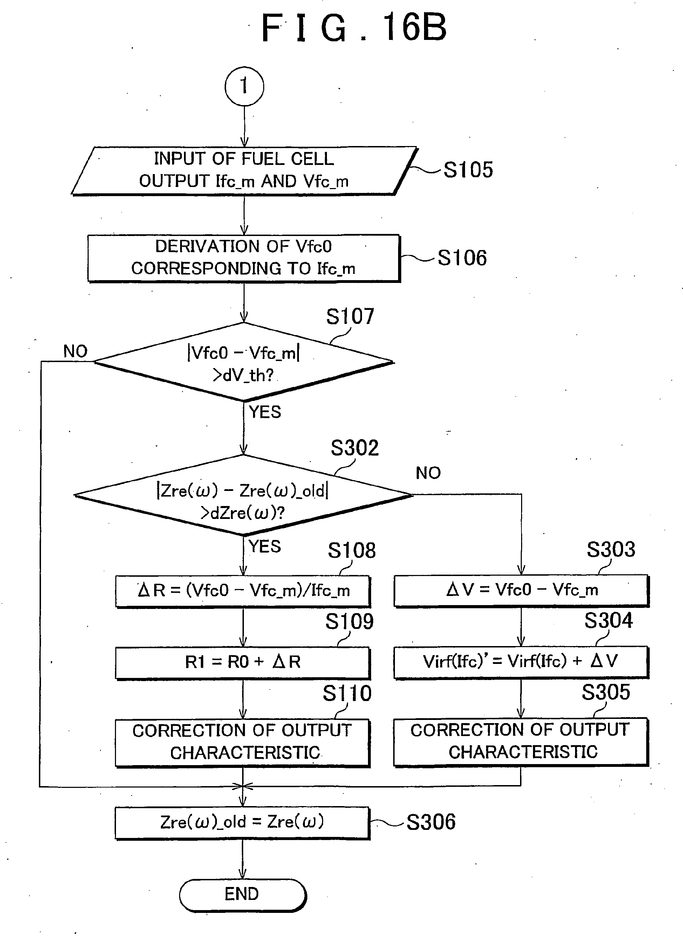

Referring to FIG. 16, a fuel cell system according to a sixth embodiment of the present invention is described. In the fifth embodiment, an example of a fuel cell system is described in which a basic internal resistance R0 of the fuel cell is calculated based on the AC impedance of the fuel cell and the air humidification amount. In this embodiment, the output characteristic of the fuel cell calculated using the basic internal resistance R0 obtained by the above method is corrected using the AC impedance. That is, in this embodiment, the same correction operation as in the fourth embodiment is performed in the fuel cell system of the fifth embodiment.

The other configuration and function of this embodiment are the same as those of the fourth and fifth embodiments. The same components as those of the fourth and fifth embodiments are therefore denoted by the same reference numerals, and their description is not repeated.

FIG. 16 shows a flowchart of the fuel cell system controlling operation performed by the ECU 20. In this operation, the ECU 20 reads the temperature Tfc of the fuel cell body 1, the airflow rate Fair, and the air pressure Pair (S100). This step is the same as that of the first embodiment shown in FIG. 5.

The ECU 20 then measures the AC impedance Zre(ω) of the fuel cell. The ECU 20 also calculates the air humidification amount Sair (S210). The ECU 20 then refers a basic internal resistance R0 from the map (see FIG. 14) based on the AC impedance Zre(ω) and the humidification amount (S401). These steps are the same as those in FIG. 15. After that, the ECU 20 performs the determination of the difference between the output voltage and the basic output characteristic of the fuel cell (S107) and the determination of the amount of variation in the AC impedance (S302), and corrects the output characteristic of the fuel cell. These steps are the same as those of the fourth embodiment shown in FIG. 13.

As described above, in this embodiment, a basic internal resistance R0 is calculated based on the AC impedance of the fuel cell and the air humidification amount, and the output characteristic of the fuel cell is corrected based on the amount of variation in the AC impedance of the fuel cell. Therefore, the output characteristic of the fuel cell can be calculated with higher accuracy than in the fourth or fifth embodiment.

**Claims**

1. A fuel cell system **characterized by** comprising:

an operation parameter storing unit (20) that stores the relation between an internal resistance of a fuel cell, excluding both a diffusion resistance of the fuel cell that is generated depending on the flow rate of reaction gas to the fuel cell and a reaction resistance of the fuel cell that is generated depending on the pressure of the reaction gas, and at least one operation parameter that indicates an operating state of the fuel cell;
a detecting unit (6, 12) that detects a present value of the at least one operation parameter;
an internal resistance estimating unit (2) that estimates the internal resistance of the fuel cell based on the detected present value of the operation parameter with reference to the relation stored in the operation parameter storing unit and setting the estimated internal resistance as a basic internal resistance;
an internal resistance-free output characteristic storing unit (20) that stores an internal resistance-free output characteristic, which is the relation between output current and output voltage of the fuel cell, excluding an influence of the internal resistance at different flow rates and pressures of air that is supplied to the fuel cell, together with the flow rate and the pressure;
a flow rate measuring unit (3) that measures a flow rate of the air that is supplied to the fuel cell;
a pressure measuring unit (4) that measures a pressure of the air that is supplied to the fuel cell;
a determining unit (20) that determines the internal resistance-free current-voltage characteristic of the fuel cell based on the flow rate and pressure of the air; and
a setting unit (20) that sets a basic current-voltage characteristic of the fuel cell based on the basic internal resistance and the internal resistance-free current-voltage characteristic.

2. The fuel cell system according to claim 1, further comprising:

an output current measuring unit (20) that measures an output current of the fuel cell;
an output voltage measuring unit (20) that measures an output voltage of the fuel cell; and
a calculating unit (20) that corrects the basic current-voltage characteristic based on the output current and the output voltage.

3. The fuel cell system according to claim 1 or 2, wherein
the operation parameter includes at least one of a temperature of the fuel cell, humidity in the fuel cell, and an impedance, which is measured across output terminals of the fuel cell using an alternating-current signal having a predetermined frequency.

4. The fuel cell system according to claim 2 or 3, wherein
the calculating unit (20) comprises:

a first correcting unit (20) that corrects the basic internal resistance of the fuel cell based on the output current and the output voltage; and a second correcting unit (20) that corrects the basic current-voltage characteristic using the corrected basic internal resistance.

5. The fuel cell system according to claim 4, wherein the calculating unit (20) further comprises:

a correction value storing unit (20) that stores the corrected basic internal resistance as a new basic internal resistance;
a third correcting unit (20) that further corrects the basic internal resistance based on the output current and the output voltage when the basic internal resistance is stored in the correction value storing unit (20); and
a fourth correcting unit (20) that corrects the basic current-voltage characteristic using the further corrected basic internal resistance.

6. The fuel cell system according to claim 2 or 3, wherein
the detecting unit (6, 12) comprises:

an impedance measuring unit (20) that measures an impedance across output terminals of the fuel cell using an alternating-current signal having a predetermined frequency; and
an impedance storing unit (20) that stores the measured impedance, and the calculating unit comprises:
a comparing unit (20) that compares the impedance measured by the impedance measuring unit (20) with a previously measured impedance that is stored in the impedance storing unit (20); and
a current-voltage characteristic correcting unit (20) that corrects the basic internal resistance when the difference between the measured impedance and the previously measured impedance is equal to or greater than a predetermined value as a result of comparison by the comparing unit (20), and corrects the internal resistance-free current-voltage characteristic when the difference is smaller than the predetermined value.

7. A method for estimating an output characteristic of a fuel cell, **characterized by** comprising:

detecting a present value of at least one operation parameter that indicates an operating state of the fuel cell;
estimating an internal resistance of the fuel cell based on the detected present value of the operation parameter with reference to the relation between an internal resistance of the fuel cell, excluding both a diffusion resistance of the fuel cell that is generated depending on the flow rate of reaction gas to the fuel cell and a reaction resistance of the fuel cell that is generated depending on the pressure of the reaction gas, and the operation parameter, and setting the estimated internal resistance as a basic internal resistance;
measuring a flow rate of air that is supplied to the fuel cell;
measuring a pressure of the air that is supplied to the fuel cell;
determining an internal resistance-free current-voltage characteristic of the fuel cell based on the flow rate and pressure of the air; and
setting a basic current-voltage characteristic of the fuel cell based on the basic internal resistance and the internal resistance-free current-voltage characteristic, which is the relation between output current and output voltage of the fuel cell, excluding the influence of the internal resistance, at different flow rates and pressures of air that is supplied to the fuel cell.

8.  The method for estimating an output characteristic of a fuel cell system according to claim 7, further comprising:

    measuring the output current and the output voltage of the fuel cell; and
    correcting the basic current-voltage characteristic based on the output current and the output voltage.

9.  The method for estimating an output characteristic of a fuel cell system according to claim 7 or 8, wherein the operation parameter includes at least one of a temperature of the fuel cell, humidity in the fuel cell, and an impedance which is measured across output terminals of the fuel cell using an alternating-current signal having a predetermined frequency.

10. The method for estimating an output characteristic of a fuel cell system according to claim 8 or 9, further comprising:

    correcting the basic internal resistance of the fuel cell based on the output current and the output voltage; and
    correcting the basic current-voltage characteristic using the corrected basic internal resistance.

11. The method for estimating an output characteristic of a fuel cell system according to claim 10, further comprising:

    storing the corrected basic internal resistance as a new basic internal resistance;
    correcting the basic internal resistance based on the output current and the output voltage when a basic internal resistance has been stored; and
    correcting the basic current-voltage characteristic with the further corrected basic internal resistance.

12. The method for estimating an output characteristic of a fuel cell system according to claim 8 or 9, further comprising:

    measuring an impedance across output terminals of the fuel cell using an alternating-current signal having a predetermined frequency;
    comparing the measured impedance with a previously measured impedance; and
    correcting the basic internal resistance when the difference between the measured impedance and the previously measured impedance is equal to or greater than a predetermined value as a result of the comparison, and correcting the internal resistance-free current-voltage characteristic when the difference is smaller than the predetermined value.

**Patentansprüche**

1.  Brennstoffzellensystem, **gekennzeichnet dadurch, dass** es folgende Merkmale aufweist:

    eine Betriebsparameter-Speichereinheit (20), die die Beziehung zwischen einem Innenwiderstand einer Brennstoffzelle, wobei davon sowohl ein Diffusionswiderstand der Brennstoffzelle, der abhängig von der Strömungsrate eines Reaktionsgases zur Brennstoffzelle erzeugt wird, als auch ein Reaktionswiderstand der Brennstoffzelle, der abhängig von dem Druck des Reaktionsgases erzeugt wird, ausgenommen sind, und zumindest einem Betriebsparameter speichert, der einen Betriebzustand der Brennstoffzelle anzeigt;
    eine Erfassungseinheit (6, 12), die einen momentanen Wert des zumindest einen Betriebsparameters erfasst;
    eine Innenwiderstands-Abschätzeinheit (2), die den Innenwiderstand der Brennstoffzelle basierend auf dem erfassten momentanen Wert des Betriebsparameters unter Bezugnahme auf die in der Betriebsparameter-Speichereinheit gespeicherte Beziehung abschätzt und den abgeschätzten Innenwiderstand als einen Grundinnenwiderstand einstellt;
    eine Einheit (20) zum Speichern einer innenwiderstandsfreien Ausgabekennlinie, die eine innenwiderstandsfreie Ausgabekennlinie speichert, die die Beziehung zwischen einem Ausgangstrom und einer Ausgangsspannung der Brennstoffzelle darstellt, wovon ein Einfluss des Innenwiderstands bei unterschiedlichen Strömungsraten und Drücken der Luft, die der Brennstoffzelle zugeführt wird, ausgenommen sind, zusammen mit der Strömungsrate und dem Druck speichert;
    eine Strömungsraten-Messeinheit (3), die eine Strömungsrate der Luft, die der Brennstoffzelle zugeführt wird, misst;
    eine Druckmesseinheit (4), die einen Druck der Luft misst, die der Brennstoffzelle zugeführt wird;
    eine Bestimmungseinheit (20), die das innenwiderstandsfreie Strom-Spannungs-Kennfeld der Brennstoffzelle basierend auf der Strömungsrate und dem Druck der Luft bestimmt; und
    eine Einstellungseinheit (20), die ein auf dem Grundinnenwiderstand und dem innenwiderstandsfreien Strom-Spannungs-Kennfeld basierendes Grund-Strom-Spannungskennfeld der Brennstoffzelle einstellt.

2. Brennstoffzellensystem nach Anspruch 1, ferner aufweisend:

eine Ausgangsstrom-Messeinheit (20), die einen Ausgangsstrom der Brennstoffzelle misst; eine Ausgangsspannungs-Messeinheit (20), die eine Ausgangsspannung der Brennstoffzelle misst; und eine Berechnungseinheit (20), die das auf dem Ausgangsstrom und der Ausgangsspannung basierende Grund-Strom-Spannungs-Kennfeld korrigiert.

3. Brennstoffzellensystem nach Anspruch 1 oder 2, wobei der Betriebsparameter zumindest entweder eine Temperatur der Brennstoffzelle, eine Feuchtigkeit in der Brennstoffzelle oder eine Impedanz beinhaltet, die an den Ausgangsanschlüssen der Brennstoffzelle unter Verwendung eines Wechselstromsignals mit einer vorbestimmten Frequenz gemessen wird.

4. Brennstoffzellensystem nach Anspruch 2 oder 3, wobei die Berechnungseinheit (20) aufweist:

eine erste Korrektureinheit (20), die den Grundinnenwiderstand der Brennstoffzelle basierend auf dem Ausgangsstrom und der Ausgangsspannung korrigiert; und eine zweite Korrektureinheit (20), die das Grund-Strom-Spannungs-Kennfeld unter Verwendung des korrigierten Grundinnenwiderstands korrigiert.

5. Brennstoffzellensystem nach Anspruch 4, wobei die Berechnungseinheit (20) ferner aufweist:

eine Korrekturwert-Speichereinheit (20), die den korrigierten Grundinnenwiderstand als eine neue Grundinnenwiderstand speichert; eine dritte Korrektureinheit (20), die den Grundinnenwiderstand basierend auf dem Ausgangsstrom und der Ausgangsspannung weiter korrigiert, wenn der Grundinnenwiderstand in der Korrekturwert-Speichereinheit (20) gespeichert ist; und eine vierte Korrektureinheit (20), die das Grund-Strom-Spannungs-Kennfeld unter Verwendung des weiter korrigierten Grundinnenwiderstands korrigiert.

6. Brennstoffzellensystem nach Anspruch 2 oder 3, wobei die Erfassungseinheit (6, 12) aufweist:

eine Impedanzmesseinheit (20), die eine Impedanz an den Ausgangsanschlüssen der Brennstoffzelle unter Verwendung eine Wechselstromsignals mit einer vorbestimmten Frequenz misst; und eine Impedanzspeichereinheit (20), die die gemessene Impedanz speichert, und die Berechnungseinheit aufweist:

eine Vergleichseinheit (20), die die durch die Impedanzmesseinheit (20) gemessene Impedanz mit einer zuvor gemessenen Impedanz, die in der Impedanzspeichereinheit (20) gespeichert ist, vergleicht; und eine Strom-Spannungs-Kennfeld-Korrektureinheit (20), die den Grundinnenwiderstand korrigiert, wenn die Differenz zwischen der gemessenen Impedanz und der zuvor gemessenen Impedanz infolge eines Vergleichs durch die Vergleichseinheit (20) größer oder gleich einem vorbestimmte Wert ist, und das innenwiderstandsfreie Strom-Spannungskennfeld korrigiert, wenn die Differenz kleiner als der vorbestimmte Wert ist.

7. Verfahren zum Abschätzen einer Ausgangskennlinie einer Brennstoffzelle, **dadurch gekennzeichnet, dass** das Verfahren folgende Schritte beinhaltet:

Erfassen eines momentanen Werts von mindestens einem Betriebsparameter, der einen Betriebszustand der Brennstoffzelle anzeigt; Abschätzen eines Innenwiderstands der Brennstoffzelle basierend auf dem erfassten momentanen Wert des Betriebsparameters unter Bezugnahme auf die Beziehung zwischen einem Innenwiderstand der Brennstoffzelle, wobei davon sowohl ein Diffusionswiderstand der Brennstoffzelle, der abhängig von der Strömungsrate eines Reaktionsgases zur Brennstoffzelle erzeugt wird, als auch ein Reaktionswiderstand der Brennstoffzelle, der abhängig vom Druck des Reaktionsgases erzeugt wird, ausgenommen sind, und dem Betriebsparameter, und Einstellen des abgeschätzten Innenwiderstands als einen Grundinnenwiderstand; Messen einer Strömungsrate der Luft, die der Brennstoffzelle zugeführt wird; Messen eines Drucks der Luft, die der Brennstoffzelle zugeführt wird; Bestimmen eines innenwiderstandsfreien Strom-Spannungskennfelds der Brennstoffzelle basierend auf der Strömungsrate und dem Druck der Luft; und

Einstellen eines auf dem Grundinnenwiderstand und dem innenwiderstandsfreien Strom-Spannungs-Kennfeld basierenden Grund-Strom-Spannungs-Kennfelds der Brennstoffzelle, das die Beziehung zwischen dem Ausgangsstrom und der Ausgangsspannung der Brennstoffzelle darstellt, wobei davon der Einfluss des Innenwiderstands bei unterschiedlichen Strömungsraten und Drücken der Luft, die der Brennstoffzelle zugeführt wird, ausgenommen ist.

8. Verfahren zum Abschätzen einer Ausgabekennlinie eines Brennstoffzellensystems nach Anspruch 7, das ferner folgende Schritte beinhaltet:

Messen des Ausgangsstroms und der Ausgangsspannung der Brennstoffzelle; und Korrigieren des Grund-Strom-Spannungs-Kennfelds basierend auf dem Ausgangsstrom und der Ausgangsspannung.

9. Verfahren zum Abschätzen einer Ausgabekennlinie eines Brennstoffzellensystems nach Anspruch 7 oder 8, wobei der Betriebsparameter zumindest entweder eine Temperatur der Brennstoffzelle, eine Feuchtigkeit in der Brennstoffzelle oder eine Impedanz beinhaltet, die an den Ausgangsanschlüssen der Brennstoffzelle unter Verwendung eines Wechselstromsignals mit einer vorbestimmten Frequenz gemessen wird.

10. Verfahren zum Abschätzen einer Ausgabekennlinie eines Brennstoffzellensystems nach Anspruch 8 oder 9, das ferner folgende Schritte beinhaltet:

Korrigieren des Grundinnenwiderstands der Brennstoffzelle basierend auf dem Ausgangsstrom und der Ausgangsspannung; und Korrigieren des Grund-Strom-Spannungs-Kennfelds unter Verwendung des korrigierten Grundinnenwiderstands.

11. Verfahren zum Abschätzen einer Ausgabekennlinie eines Brennstoffzellensystems nach Anspruch 10, das ferner folgende Schritte beinhaltet:

Speichern des korrigierten Grundinnenwiderstands als ein neuer Grundinnenwiderstand; Korrigieren des Grundinnenwiderstands basierend auf dem Ausgangsstroms und der Ausgangsspannung, wenn ein Grundinnenwiderstand gespeichert worden ist; und Korrigieren des Grund-Strom-Spannungskennfelds mit dem ebenfalls korrigierten Grundinnenwiderstand.

12. Verfahren zum Abschätzen einer Ausgabekennlinie eines Brennstoffzellensystems nach Anspruch 8 oder 9, das ferner folgende Schritte beinhaltet:

Messen einer Impedanz an den Ausgangsanschlüssen der Brennstoffzelle unter Verwendung eines Wechselstromsignals mit einer vorbestimmten Frequenz; Vergleichen der gemessenen Impedanz mit einer zuvor gemessenen Impedanz; und Korrigieren des Grundinnenwiderstands, wenn die Differenz zwischen der gemessenen Impedanz und der zuvor gemessenen Impedanz infolge des Vergleichs größer oder gleich einem vorbestimmten Wert ist, und Korrigieren des innenwiderstandsfreien Strom-Spannungs-Kennfelds, wenn die Differenz kleiner als der vorbestimmte Wert ist.

## Revendications

1. Système de pile à combustible **caractérisé en ce qu'**il comprend :

une unité (20) de mémorisation de paramètres de fonctionnement qui mémorise la relation entre la résistance interne d'une pile à combustible, en excluant à la fois la résistance de diffusion de la pile à combustible qui est engendrée en fonction du débit de gaz de réaction vers la pile à combustible et la résistance de réaction de la pile à combustible qui est engendrée en fonction de la pression du gaz de réaction, et au moins un paramètre de fonctionnement qui indique un état de fonctionnement de la pile à combustible ;
une unité (6, 12) de détection qui détecte une valeur actuelle de l'au moins un paramètre de fonctionnement ;
une unité (2) d'estimation de résistance interne qui estime la résistance interne de la pile à combustible en se basant sur la valeur actuelle détectée du paramètre de fonctionnement en se référant à la relation mémorisée dans l'unité de mémorisation de paramètres de fonctionnement et la fixation de la résistance interne estimée comme résistance interne de base ;
une unité (20) de mémorisation de caractéristique de sortie sans résistance interne qui mémorise une caractéristique de sortie sans résistance interne, qui est la relation entre un courant de sortie et une tension de sortie de la pile à combustible, en excluant l'influence de la résistance interne à des débits et pressions différents de l'air qui est fourni à la pile à combustible, conjointement avec le débit et la pression ;
une unité (3) de mesure de débit qui mesure le débit de l'air qui est fourni à la pile à combustible ;

une unité (4) de mesure de pression qui mesure la pression de l'air qui est fourni à la pile à combustible ;

une unité (20) de détermination qui détermine la caractéristique de courant-tension sans résistance interne de la pile à combustible en se basant sur le débit et la pression de l'air ; et

une unité (20) de fixation qui fixe une caractéristique de courant-tension de base de la pile à combustible en se basant sur la résistance interne de base et sur la caractéristique de courant-tension sans résistance interne.

2. Système de cellule à combustible selon la revendication 1, comprenant en outre :

une unité (20) de mesure de courant de sortie qui mesure le courant de sortie de la pile à combustible ;

une unité (20) de mesure de tension de sortie qui mesure la tension de sortie de la pile à combustible ; et

une unité (20) de calcul qui corrige la caractéristique de courant-tension de base en se basant sur le courant de sortie et la tension de sortie.

3. Système de cellule à combustible selon la revendication 1 ou 2, dans lequel le paramètre de fonctionnement inclut au moins l'une de la température de la pile à combustible, de l'humidité dans la pile à combustible et d'une impédance qui est mesurée aux bornes de sortie de la pile à combustible en utilisant un signal de courant alternatif ayant une fréquence prédéterminée.

4. Système de cellule à combustible selon la revendication 2 ou 3, dans lequel l'unité (20) de calcul comprend :

une première unité (20) de correction qui corrige la résistance interne de base de la pile à combustible en se basant sur le courant de sortie et la tension de sortie ; et

une deuxième unité (20) de correction qui corrige la caractéristique de courant-tension de base en utilisant la résistance interne de base corrigée.

5. Système de cellule à combustible selon la revendication 4, dans lequel l'unité (20) de calcul comprend en outre :

une unité (20) de mémorisation de valeur de correction qui mémorise la résistance interne de base corrigée en tant que nouvelle résistance interne de base ;

une troisième unité (20) de correction qui corrige à nouveau la résistance interne de base en se basant sur le courant de sortie et la tension de sortie lorsque la résistance interne de base est mémorisée dans l'unité (20) de mémorisation de valeur de correction ; et

une quatrième unité (20) de correction qui corrige la caractéristique de courant-tension de base en utilisant la résistance interne de base corrigée à nouveau.

6. Système de cellule à combustible selon la revendication 2 ou 3, dans lequel l'unité (6, 12) de détection comprend :

une unité (20) de mesure d'impédance qui mesure l'impédance aux bornes de sortie de la pile à combustible en utilisant un signal de courant alternatif ayant une fréquence prédéterminée ; et

une unité (20) de mémorisation d'impédance qui mémorise l'impédance mesurée, et

dans lequel l'unité de calcul comprend :

une unité (20) de comparaison qui compare l'impédance mesurée par l'unité (20) de mesure d'impédance avec une impédance mesurée antérieurement qui est mémorisée dans l'unité (20) de mémorisation d'impédance ; et

une unité (20) de correction de caractéristique de courant-tension qui corrige la résistance interne de base lorsque la différence entre l'impédance mesurée et l'impédance mesurée antérieurement est égale ou supérieure à une valeur prédéterminée comme résultat de comparaison par l'unité (20) de comparaison, et qui corrige la caractéristique de courant-tension sans résistance interne lorsque la différence est plus petite que la valeur prédéterminée.

7. Procédé d'estimation d'une caractéristique de sortie d'une pile à combustible, **caractérisé en ce qu'**il comprend :

la détection d'une valeur actuelle d'au moins un paramètre de fonctionnement qui indique un état de fonctionnement de la pile à combustible ;

l'estimation de la résistance interne de la pile à combustible en se basant sur la valeur actuelle détectée du paramètre de fonctionnement en se référant à la relation entre la résistance interne de la pile à combustible, en excluant à la fois la résistance de diffusion de la pile à combustible qui est engendrée en fonction du débit de gaz de réaction vers la pile à combustible et la résistance de réaction de la pile à combustible qui est engendrée en fonction de la pression du gaz de réaction, et le paramètre de fonctionnement et la fixation de la résistance interne estimée comme résistance interne de base ;

la mesure du débit de l'air qui est fourni à la pile à combustible ;

la mesure de la pression de l'air qui est fourni à la pile à combustible ;

la détermination de la caractéristique de courant-tension sans résistance interne de la pile à combustible en se basant sur le débit et la pression de l'air ; et

la fixation d'une caractéristique de courant-tension de base de la pile à combustible en se basant sur la résistance interne de base et sur la caractéristique de courant-tension sans résistance interne, qui est la relation entre le courant de sortie et l'intensité de sortie de la pile à combustible, en excluant l'influence de la résistance interne, à des débits et pressions différents de l'air qui est fourni à la pile à combustible.

8.  Procédé d'estimation d'une caractéristique de sortie d'un système de pile à combustible selon la revendication 7, comprenant en outre :

    la mesure du courant de sortie et de l'intensité de sortie de la pile à combustible ; et

    la correction de la caractéristique de courant-tension de base en se basant sur le courant de sortie et l'intensité de sortie.

9.  Procédé d'estimation d'une caractéristique de sortie d'un système de pile à combustible selon la revendication 7 ou 8, dans lequel le paramètre de fonctionnement inclut au moins l'une de la température de la pile à combustible, de l'humidité dans la pile à combustible, et de l'impédance qui est mesurée aux bornes de sortie de la pile à combustible en utilisant un signal de courant alternatif ayant une fréquence prédéterminée.

10. Procédé d'estimation d'une caractéristique de sortie d'un système de pile à combustible selon la revendication 8 ou 9, comprenant en outre :

    la correction de la résistance interne de base de la pile à combustible en se basant sur le courant de sortie et la tension de sortie ; et

    la correction de la caractéristique de courant-tension de base en utilisant la résistance interne de base corrigée.

11. Procédé d'estimation d'une caractéristique de sortie d'un système de pile à combustible selon la revendication 10, comprenant en outre :

    la mémorisation, comme une nouvelle résistance interne de base, de la résistance interne de base corrigée ;

la correction de la résistance interne de base en se basant sur le courant de sortie et la tension de sortie lorsqu'une résistance interne de base a été mémorisée ; et

la correction de la caractéristique de courant-tension de base à l'aide de la résistance interne de base corrigée à nouveau.

12. Procédé d'estimation d'une caractéristique de sortie d'un système de pile à combustible selon la revendication chiffre 8 ou 9, comprenant en outre :

    la mesure de l'impédance aux bornes de sortie de la pile à combustible en utilisant un signal de courant alternatif ayant une fréquence prédéterminée ;

    la comparaison de l'impédance mesurée avec une impédance mesurée antérieurement ; et

    la correction de la résistance interne de base lorsque la différence entre l'impédance mesurée et l'impédance mesurée antérieurement est égale ou supérieure à une valeur prédéterminée comme résultat de la comparaison, et la correction de la caractéristique de courant-tension sans résistance interne lorsque la différence est plus petite que la valeur prédéterminée.

# F I G . 1

# FIG.2

R0

Tfc

# FIG.3

Vfc

PRESSURE: HIGH

PRESSURE: LOW

Ifc

# F I G . 4

Vfc

FLOW RATE: LOW  FLOW RATE: HIGH

Ifc

# F I G . 5

```
┌─────────────────────────────┐
( OUTPUT CHARACTERISTIC       )
( ESTIMATING OPERATION        )
└─────────────────────────────┘
```

INPUT OF FUEL CELL TEMPERATURE Tfc
INPUT OF AIRFLOW RATE Fair,
AND AIR PRESSURE Pair — S100

CALCULATION OF BASIC
INTERNAL RESISTANCE R0 — S101

CALCULATION OF
IR-FREE OUTPUT
CHARACTERISTIC Virf(Ifc) — S102

CALCULATION OF BASIC OUTPUT
CHARACTERISTIC — S103

SETTING OF FUEL CELL OPERATION
POINT & CONTROL OF OUTPUT — S104

INPUT OF FUEL CELL
OUTPUT Ifc_m, Vfc_m — S105

DERIVATION OF Vfc0 ON BASIC OUTPUT
CHARACTERISTIC CORRESPONDING TO Ifc_m — S106

S107
$|Vfc0 - Vfc\_m|$
$> dV\_th?$ — NO

YES

$\Delta R = (Vfc0 - Vfc\_m)/Ifc\_m$ — S108

$R1 = R0 + \Delta R$ — S109

CORRECTION OF OUTPUT CHARACTERISTIC — S110

END

# F I G . 6

# F I G . 7

RELATION AMONG Tfc, Sair AND R0

# F I G . 8

OUTPUT CHARACTERISTIC
ESTIMATING OPERATION

INPUT OF FUEL CELL TEMPERATURE Tfc
INPUT OF AIRFLOW RATE Fair, AND AIR PRESSURE Pair          S200
INPUT OF AIR HUMIDIFICATION AMOUNT Sair

CALCULATION OF BASIC
INTERNAL RESISTANCE R0          S201

TO S102 IN FIG. 5

# FIG.9

# F I G . 10

# F I G . 11

```
┌─────────────────────────────┐
│   OUTPUT CHARACTERISTIC      │
│   ESTIMATING OPERATION       │
└─────────────────────────────┘
              │
              ▼
╱─────────────────────────────────────╱
│  INPUT OF FUEL CELL TEMPERATURE Tfc  │ ~ S100
│  INPUT OF AIRFLOW RATE Fair,         │
│  AND AIR PRESSURE Pair               │
╱─────────────────────────────────────╱
              │
              ▼
┌─────────────────────────────┐
│      CALCULATION OF          │ ~ S210
│   HUMIDIFICATION AMOUNT Sair │
└─────────────────────────────┘
              │
              ▼
┌─────────────────────────────┐
│    CALCULATION OF BASIC      │ ~ S201
│   INTERNAL RESISTANCE R0     │
└─────────────────────────────┘
              │
              ▼
       TO S102 IN FIG. 5
```

# F I G . 12

# F I G . 13

$$\text{OUTPUT CHARACTERISTIC} \atop \text{ESTIMATING OPERATION}$$

SAME AS S100 TO S104 IN FIG. 5

INPUT OF FUEL CELL
OUTPUT Ifc_m AND Vfc_m —S105

INPUT OF AC IMPEDANCE Zre($\omega$) —S301

DERIVATION OF Vfc0 ON BASIC OUTPUT
CHARACTERISTIC CORRESPONDING TO Ifc_m —S106

S107

NO ← |Vfc0 − Vfc_m|
>dV_th?

YES

S302

|Zre($\omega$) − Zre($\omega$)_old|
>dZre($\omega$)? → NO

YES    S108          S303

$\Delta R$ = (Vfc0 − Vfc_m)/Ifc_m    $\Delta V$ = Vfc0 − Vfc_m

S109          S304

R1 = R0 + $\Delta R$    Virf(Ifc)' = Virf(Ifc) + $\Delta V$

S110          S305

CORRECTION OF OUTPUT
CHARACTERISTIC    CORRECTION OF OUTPUT
CHARACTERISTIC

Zre($\omega$)_old = Zre($\omega$) —S306

END

# F I G . 14

RO

HUMIDIFICATION
AMOUNT: SMALL

HUMIDIFICATION
AMOUNT: LARGE

Zre($\omega$)

# FIG.15A

$$\boxed{\begin{array}{c}\text{OUTPUT CHARACTERISTIC}\\\text{ESTIMATING OPERATION}\end{array}}$$

INPUT OF FUEL CELL TEMPERATURE Tfc
INPUT OF AIRFLOW RATE Fair,
AND AIR PRESSURE Pair — S100

INPUT OF IMPEDANCE Zre($\omega$) — S301

CALCULATION OF
HUMIDIFICATION AMOUNT Sair — S210

CALCULATION OF BASIC
INTERNAL RESISTANCE R0 — S401

CALCULATION OF
IR-FREE OUTPUT
CHARACTERISTIC Virf(Ifc) — S102

CALCULATION OF BASIC OUTPUT
CHARACTERISTIC — S103

SETTING OF FUEL CELL OPERATION
POINT & CONTROL OF OUTPUT — S104

( 1 )

# FIG.15B

① 1

S105
INPUT OF FUEL CELL
OUTPUT Ifc_m AND Vfc_m

S106
DERIVATION OF Vfc0 ON BASIC OUTPUT
CHARACTERISTIC CORRESPONDING TO Ifc_m

S107
$|Vfc0 - Vfc\_m|$
$> dV\_th?$

NO

YES

S108
$\Delta R = (Vfc0 - Vfc\_m)/Ifc\_m$

S109
$R1 = R0 + \Delta R$

S110
CORRECTION OF OUTPUT CHARACTERISTIC

END

# FIG. 16A

OUTPUT CHARACTERISTIC
ESTIMATING OPERATION

INPUT OF Tfc, Fair AND Pair — S100

INPUT OF AC IMPEDANCE Zre($\omega$) — S301

CALCULATION OF
HUMIDIFICATION AMOUNT Sair — S210

CALCULATION OF BASIC
INTERNAL RESISTANCE R0 — S401

CALCULATION OF
IR-FREE OUTPUT
CHARACTERISTIC Virf(Ifc) — S102

CALCULATION OF BASIC OUTPUT
CHARACTERISTIC — S103

SETTING OF FUEL CELL OPERATION
POINT & CONTROL OF OUTPUT — S104

1

# F I G . 16B

(1)

INPUT OF FUEL CELL
OUTPUT Ifc_m AND Vfc_m — S105

DERIVATION OF Vfc0
CORRESPONDING TO Ifc_m — S106

S107

$|Vfc0 - Vfc\_m|$
$>dV\_th?$

NO

YES

S302

$|Zre(\omega) - Zre(\omega)\_old|$
$>dZre(\omega)?$

NO

YES      S108

$\Delta R = (Vfc0 - Vfc\_m)/Ifc\_m$

S303

$\Delta V = Vfc0 - Vfc\_m$

S109

$R1 = R0 + \Delta R$

S304

$Virf(Ifc)' = Virf(Ifc) + \Delta V$

S110

CORRECTION OF OUTPUT
CHARACTERISTIC

S305

CORRECTION OF OUTPUT
CHARACTERISTIC

$Zre(\omega)\_old = Zre(\omega)$ — S306

END

**REFERENCES CITED IN THE DESCRIPTION**

**Patent documents cited in the description**

- JP 2002231295 A

- JP 2003297408 A